# EUROPEAN PATENT SPECIFICATION

(11) **EP 3 866 268 B1**
(45) Date of publication and mention of the grant of the patent: **04.12.2024**
(21) Application number: 19871296.0
(22) Date of filing: 08.10.2019
(51) Int. Cl.: H05K 7/14, H01R 9/26, H01R 13/64, H01R 13/66, H01R 43/00

(54) **MODULAR DEVICE**
MODULARE VORRICHTUNG
DISPOSITIF MODULAIRE

(30) Priority: 12.10.2018 KR 20180121643
(43) Date of publication of application: 18.08.2021
(73) Proprietor: Autonics Corporation, Busan 48002 (KR)
(72) Inventor: YANG, Seongdae, Bucheon-si, Gyeonggi-do 14598 (KR); YOUN, Hyungseok, Gijang-gun, Busan 46023 (KR); CHOI, Jeongho, Yongin-si, Gyeonggi-do 16836 (KR)
(74) Representative: Frenkel, Matthias Alexander
(86) International application number: PCT/KR2019/013242
(87) International publication number: WO 2020/076074

(56) References cited:
- EP-A1- 1 119 229
- JP-U- H0 558 683
- KR-A- 20160 074 491
- KR-A- 20180 079 552
- KR-A- 20180 079 552
- KR-U- 19990 002 070
- KR-Y1- 200 293 300
- KR-Y1- 200 293 300
- US-B2- 9 761 965

## Description

### [TECHNICAL FIELD]

The present invention relates to a modular device.

### [BACKGROUND ART]

The I/O module refers to a module that controls input and/or output. In the input/output module, a PCB board may be mounted inside and a terminal block may be mounted outside. The terminal block may be provided with input/output terminals electrically connected to the PCB. By connecting an external cable to the input/output terminal, signals can be transmitted between the external device and the PCB.

EP 1 119 229 A1 discloses a coded connector arrangement for permitting a displacement of a pair of authorized components in a given direction toward each other from a diconnected position to a fully connected position.

Recently, many studies have been conducted to prevent electrical damage to the module that may occur during the operation of such an I/O module.

### [DISCLOSURE]

### [TECHNICAL PROBLEM]

It is an object of the present invention to solve the above and other problems. Another object may be to be able to easily replace modular components.

Another object may be to prevent damage that may occur due to misassembly during replacement or repair work of modular components.

Another object may be to improve the matchability of components during replacement or repair work of modular components.

Another object may be to prevent electrical shorts during replacement or repair work of modular components.

### [TECHNICAL SOLUTION]

The invention is defined in the appended claims.

### [ADVANTAGEOUS EFFECTS]

According to at least one of the embodiments of the present invention, it is possible to easily replace modular components.

According to at least one of the embodiments of the present invention, it is possible to prevent damage that may occur due to incorrect assembly during replacement or repair work of modular components.

According to at least one of the embodiments of the present invention, it is possible to improve the matchability of the components during replacement or repair work of modular components.

According to at least one of the embodiments of the present invention, it is possible to prevent an electrical short during replacement or repair work of modular components.

### [DESCRIPTION OF DRAWINGS]

Figures 1 to 3 shows examples of a modular device according to an embodiment of the invention.
Figures 4 to 10 shows examples of a modular device assembly according to an embodiment of the invention.

### [MODE FOR INVENTION]

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof

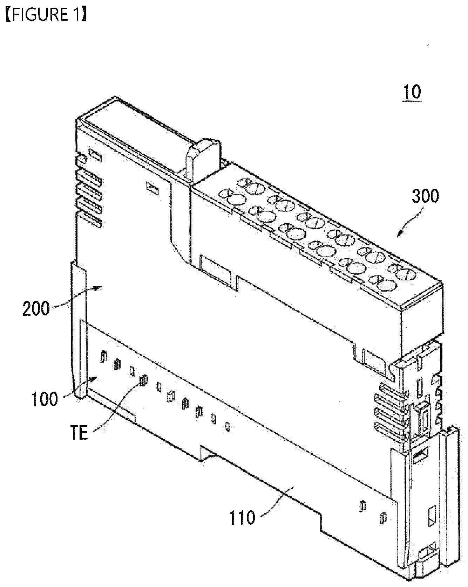

Referring to FIG. 1, a modular device 10 may include a base 100, a body 200, and a terminal 300. The base 100 may include connection terminals (connection electrodes, TE) exposed to the outside of a case 110. The plurality of modular devices 10 may be electrically connected to each other by the connection terminals TE exposed to the outside of the case 110. The body 200 may be mounted on the base 100, and the terminal 300 may be mounted on the body 200.

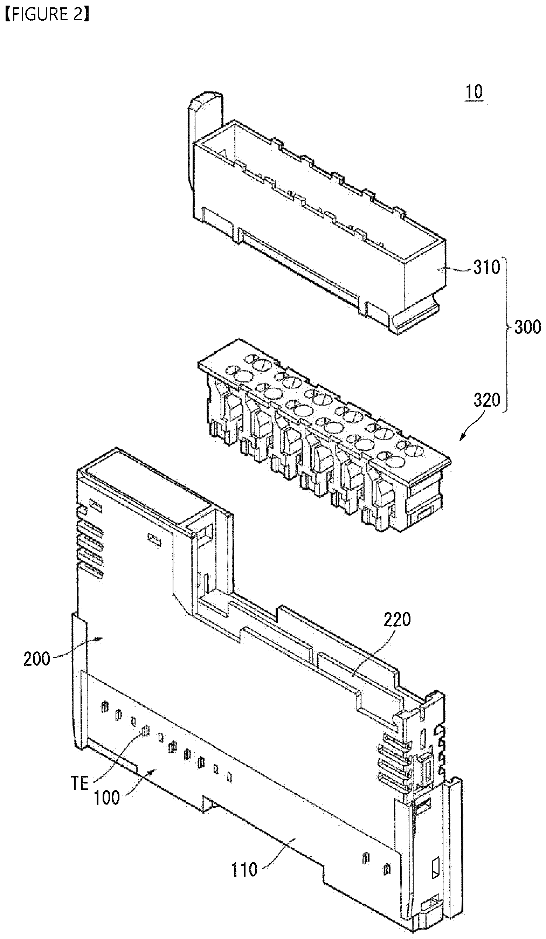

Referring to FIG. 2, a terminal 300 may include a case 310 and a terminal block 320. The case 310 provides an internal accommodation space, and the terminal block 320 may be accommodated or mounted in the internal accommodation space of the case 310. A plurality of cables may be electrically connected to the terminal block 320 outside the case 310. The terminal block 320 may be electrically connected to a PCB 220. The terminal block 320 may be referred to as a port 320.

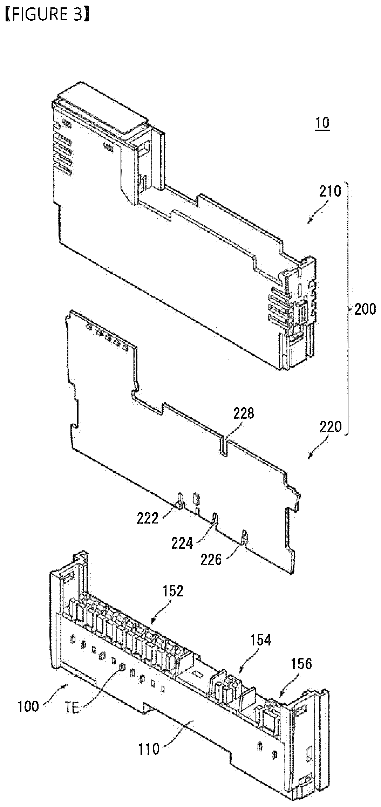

Referring to FIG. 3, a body 200 may include a case 210 and a PCB 220. The PCB 220 may be accommodated or mounted inside the case 210. The PCB 220 may be inserted or mounted in slots 152, 154, and 156 provided in the base 100. The PCB 220 may be electrically connected to the connection terminal TE.

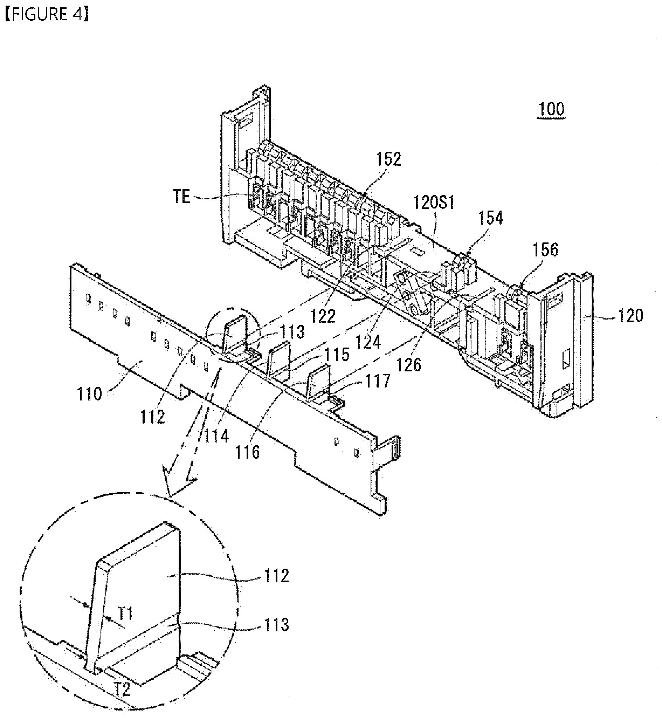

Referring to FIG. 4, the base 100 may include a first case 120 and a second case 110. The first case 120 may be combined with the second case 110. The first case 120 may have a first surface 120S1 facing the body 200 (see FIG. 3). Slits 122, 124, and 126 may be formed on the first surface 120S1. The slits 122, 124, and 126 may include a first slit 122, a second slit 124, and a third slit 126. The number of slits 122, 124, and 126 may be modified.

The second case 110 may include ribs 112, 114, and 116. The ribs 112, 114, and 116 may include a first rib 112, a second rib 114, and a third rib 116. When the first case 110 and the second case 120 are coupled, the first rib 112 may be inserted into the first slit 122, the second rib 114 may be inserted into the second slit 124, and the third rib 116 may be inserted into the third slit 126.

The ribs 112, 114, and 116 may include necks 113, 115, and 117. The thickness T1 of the ribs 112, 114, and 116 may be greater than the thickness T2 of the necks 113, 115, and 117. The ribs 112, 114, and 116 may be easily cut because of the necks 113, 115, and 117.

For example, an operator can manually cut the ribs 112, 114, and 116 around the necks 113, 115, and 117. At this time, the cut ribs 112, 114, and 116 may leave a residue or a debris or remains. Here, the residue may be a part of the ribs 112, 114, and 116 left after being cut.

For another example, an operator or automated machine may cut the ribs 112, 114, 116 by a laser cutting machine. At this time, the cut ribs 112, 114, 116 can be cleanly deleted without residue. In this case, the necks 113, 115, and 117 may not be necessary.

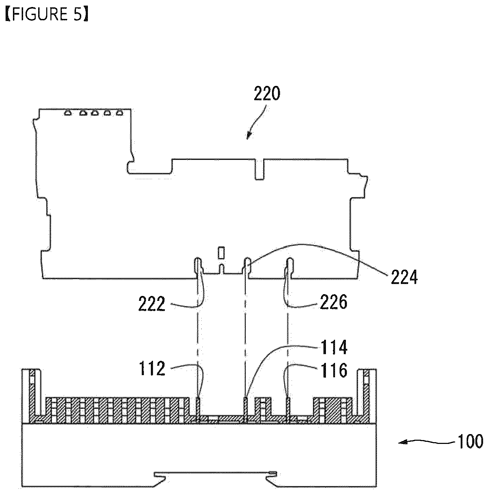

Referring FIGs. 5 to 8, the PCB 220 may have a constant voltage and/or current and/or signal processing capacity according to required specifications (AC, DC, etc.). According to the specifications of the PCB 220, the receiving portions 222, 224, and 226 of the PCB 220 may be different. The receiving portions 222, 224, and 226 may be formed on the PCB 220 to be cut-out from a side of the PCB 220 into the PCB 220. The receiving portions 222,224,226 may be referred to as lower receiving portions 222,224,226 of the PCB 220.

Referring to FIG. 5, the PCB 220 may include a first receiving portion 222, a second receiving portion 224, and a third receiving portion 226. The first rib 112 may be inserted into the first receiving portion 222, the second rib 114 may be inserted into the second receiving portion 224, and the third rib 116 may be inserted into the third receiving portion 226.

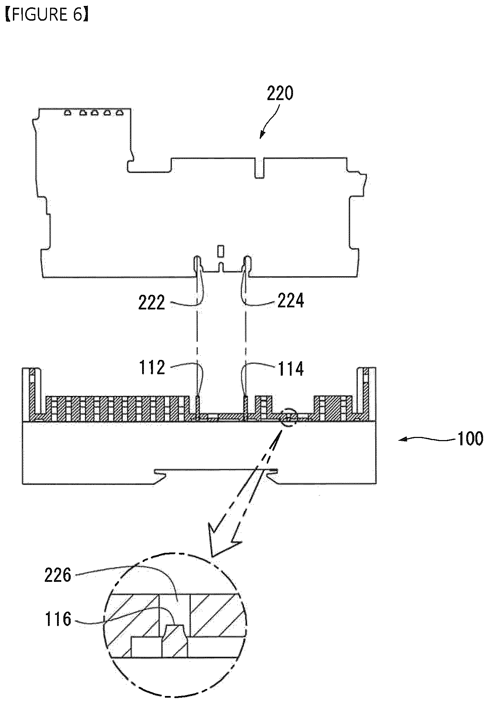

Referring to FIG. 6, the PCB 220 may include a first receiving portion 222 and a second receiving portion 224. The first rib 112 may be inserted into the first receiving portion 222 and the second rib 114 may be inserted into the second receiving portion 224. The third rib 116 (refer to FIG. 5) may be cut or deleted.

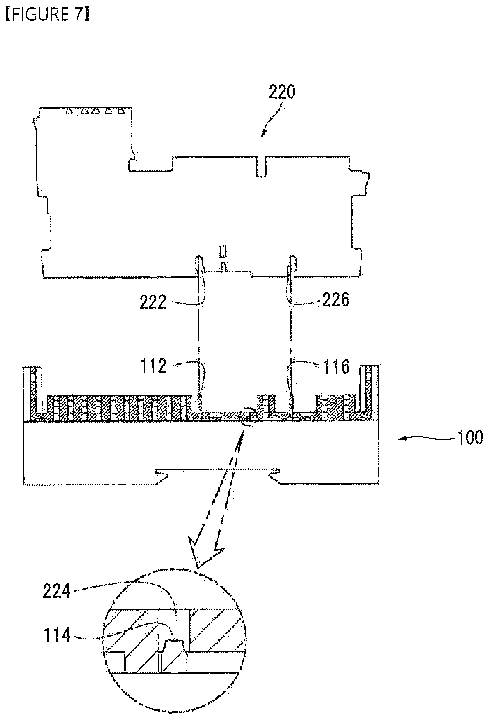

Referring to FIG. 7, the PCB 220 may include a first receiving portion 222 and a third receiving portion 226. The first rib 112 may be inserted into the first receiving portion 222, and the third rib 116 may be inserted into the third receiving portion 226. The second rib 114 (see FIG. 5) may be cut or deleted.

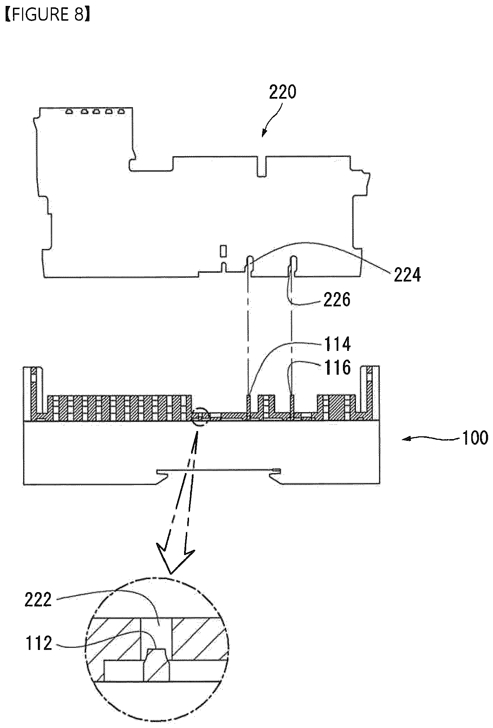

Referring to FIG. 8, the PCB 220 may include a second receiving portion 224 and a third receiving portion 226. The second rib 114 may be inserted into the second receiving portion 224 and the third rib 116 may be inserted into the third receiving portion 226. The first rib 112 (refer to FIG. 5) may be cut or deleted.

The cutting or deletion of the ribs 112, 114, 116 may be performed during the production of the modular device 10. Accordingly, in the field where the modular device 10 is installed and/or replaced and/or maintained, the operator can combine the PCB 220 and the base 100 requiring a certain specification without error. That is, damage to the modular device 10 due to erroneous coupling can be prevented.

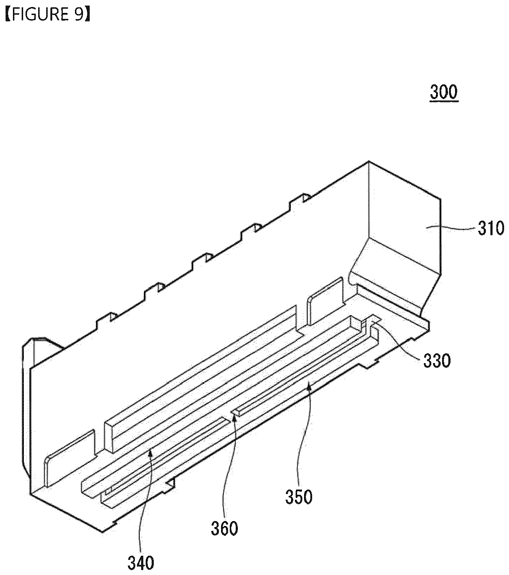

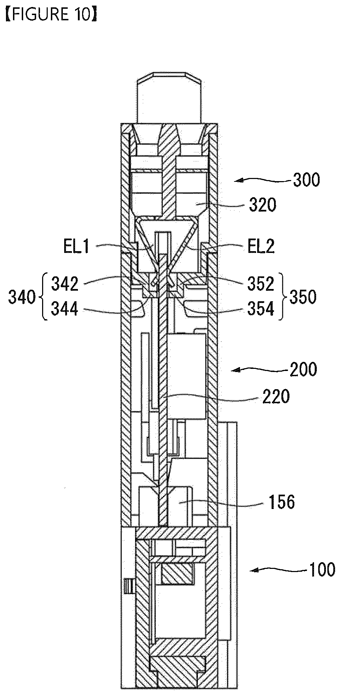

Referring to FIGs. 3, 9, and 10, a slot 330 may be formed on the lower part or lower surface of the terminal 300. The slot 330 is elongated so that the PCB 220 (refer to FIG. 3) may be inserted into the slot 330. A first side wall 340 may protrude from the lower surface of the terminal 300 and may be extends along the length direction of the slot 330. A second side wall 350 protrudes from the lower surface of the terminal 300 and extends along the length direction of the slot 330. The first side wall 340 may be opposite to the second side wall 350 with respect to the slot 330. That is, the slot 330 may be located between the first side wall 340 and the second side wall 350. The bridge 360 may connect the first side wall 340 and the second side wall 350. The bridge 360 may be formed to extend in a direction crossing the length direction of the first side wall 340 and the second side wall 350.

The first side wall 340 may include a vertical portion 342 and a horizontal portion 344. The vertical portion 342 may be positioned adjacent to a side surface of the electrode EL1 provided on the terminal block 320. The horizontal portion 344 may be positioned adjacent to the lower end of the electrode EL1. The horizontal portion 344 may cover the lower end of the electrode EL1. The horizontal portion 344 may be connected to the vertical portion 342. For example, the vertical portion 342 and the horizontal portion 344 may have a L shape as a whole. The electrode EL1 may be referred to as a terminal electrode EL1.

The second side wall 350 may include a vertical portion 352 and a horizontal portion 354. The vertical portion 352 may be positioned adjacent to a side surface of the electrode EL2 provided on the terminal block 320. The horizontal portion 354 may be positioned adjacent to the lower end of the electrode EL2. The horizontal portion 354 may cover the lower end of the electrode EL2. The horizontal portion 354 may be connected to the vertical portion 352. For example, the vertical portion 352 and the horizontal portion 354 may have a L shape as a whole.

Accordingly, the electrodes EL1 and EL2 may not be exposed to the outside of the case 310 of the terminal 300. It is possible to prevent damage that may occur by contacting the electrodes EL1 and EL2 while the operator is replacing the terminal 300 in the field.

Due to the features disclosed in the above-described embodiments, the operator can perform the installation or replacement of the modular device even when the modular device is operating or power is supplied to the modular device.

Certain embodiments or other embodiments of the disclosure described above are not mutually exclusive or distinct from each other. Any or all elements of the embodiments of the disclosure described above may be combined or combined with each other in configuration or function

Although embodiments have been described with reference to a number of illustrative embodiments thereof, it should be understood that numerous other modifications and embodiments can be devised by those skilled in the art that will fall within the scope of the appended claims.

More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art, within the scope of the appended claims.

## Claims

1. A modular device (10) comprising:
a base (100) including a connection electrode (TE) exposed to the outside of the modular device (10);
a body (200) including a PCB (220) electrically connected to the connection electrode (TE), the body (200) mounted on the base (100);
a terminal (300) mounted on the body and including a port (320) electrically connected with the PCB (220);
wherein the base (100) comprises:
a first case (120); and
a second case (110) coupled to the first case (120),
wherein the first case (120) includes:
a first surface (120S1) facing the body (200); and
a plurality of slits (122, 124, 126) formed on the first surface (120S1),
wherein the second case (110) comprises:
at least one of ribs (112, 114, 116) extending from the base (100) toward the body (200) and inserted into the plurality of slits (122, 124, 126),
wherein at least one of the plurality of slits (126) is empty with the at least one of ribs (116),
wherein the PCB (220) comprises a lower receiving portion (222, 224) such that the at least one of ribs (112, 114) is inserted into the lower receiving portion (222, 224).

2. The modular device (10) of claim 1, wherein the plurality of slits (122, 124, 126) includes a first slit (122, 124) and a second slit (126), and
wherein the at least one of ribs (112, 114, 116) includes a first rib (112, 114) inserted into the first slit (122, 124) and a debris (116) formed on the base (100), the debris (116) corresponding to the second slit (126).

3. The modular device (10) of claim 2, wherein the first rib (112, 114) includes a neck (113, 115) at a lower part of the first rib (112, 114), the neck (113, 115) having a thickness (T2) smaller than a thickness (T1) of the first rib (112, 114).

4. The modular device (10) of claim 2, wherein the terminal (300) comprises:
a slot (330) formed on a lower surface of the terminal (300), the PCB (220) inserted into the slot (330);
a first side wall (340) protruded from the lower surface of the terminal (300) and extended along a length direction of the slot (330); and
a second side wall (350) protruded from the lower surface of the terminal (300) and extended along the length direction of the slot (330), the second side wall (350) opposite to the first side wall (340) with respect to the slot (330).

5. The modular device (10) of claim 4, wherein the terminal (300) further comprises a bridge (360) connected with the first side wall (340) and the second side wall (350) in a direction crossing a length direction of the first side wall (340) and the second side wall (350).

6. The modular device (10) of claim 5, wherein the PCB (220) includes a upper receiving portion (228) formed to cut-out into the PCB (220) such that the bridge (360) is inserted into the upper receiving portion (228).

7. The modular device (10) of claim 4, wherein the terminal (300) further includes a terminal electrode (EL1) inside of the terminal (300), the terminal electrode (EL1) adjacent to the first side wall (340) and the second side wall (350), and
wherein at least one of the first side wall (340) and the second side wall (350) covers the terminal electrode (EL1).

## Patentansprüche

1. Eine modulare Vorrichtung (10), die umfasst:
Eine Basis (100) mit einer Anschlusselektrode (TE), die an der Außenseite der modularen Vorrichtung (10) freiliegt;
einen Körper (200) mit einer Leiterplatte (220), die elektrisch mit der Anschlusselektrode (TE) verbunden ist, wobei der Körper (200) auf der Basis (100) montiert ist;
ein Terminal (300), das auf dem Körper montiert ist und einen Anschluss (320) aufweist, der elektrisch mit der Leiterplatte (220) verbunden ist;
wobei die Basis (100) umfasst:
ein erstes Gehäuse (120); und
ein zweites Gehäuse (110), das mit dem ersten Gehäuse (120) gekoppelt ist,
wobei das erste Gehäuse (120) aufweist:
eine erste Oberfläche (120S1), die dem Körper (200) zugewandt ist; und
eine Vielzahl von Schlitzen (122, 124, 126), die auf der ersten Oberfläche (120S1) ausgebildet sind,
wobei das zweite Gehäuse (110) umfasst:
mindestens eine von Rippen (112, 114, 116), die sich von der Basis (100) zum Körper (200) hin erstrecken und in die Vielzahl von Schlitzen (122, 124, 126) eingesetzt sind,
wobei mindestens einer der Vielzahl von Schlitzen (126) mit der mindestens einen von Rippen (116) leer ist,
wobei die Leiterplatte (220) einen unteren Aufnahmeabschnitt (222, 224) aufweist, so dass die mindestens eine von Rippen (112, 114) in den unteren Aufnahmeabschnitt (222, 224) eingeführt ist.

2. Modulare Vorrichtung (10) nach Anspruch 1, wobei die Vielzahl von Schlitzen (122, 124, 126) einen ersten Schlitz (122, 124) und einen zweiten Schlitz (126) aufweist, und
wobei die mindestens eine von Rippen (112, 114, 116) eine erste Rippe (112, 114), die in den ersten Schlitz (122, 124) eingesetzt ist, und einen auf der Basis (100) gebildeten Trümmer (116) umfasst, wobei der Trümmer (116) dem zweiten Schlitz (126) entspricht.

3. Modulare Vorrichtung (10) nach Anspruch 2, wobei die erste Rippe (112, 114) einen Hals (113, 115) an einem unteren Teil der ersten Rippe (112, 114) aufweist, wobei der Hals (113, 115) eine Dicke (T2) hat, die kleiner ist als eine Dicke (T1) der ersten Rippe (112, 114).

4. Modulare Vorrichtung (10) nach Anspruch 2, wobei das Terminal (300) umfasst:
einen Schlitz (330), der an einer unteren Fläche des Terminals (300) ausgebildet ist, wobei die Leiterplatte (220) in den Schlitz (330) eingesetzt ist;
eine erste Seitenwand (340), die von der unteren Fläche des Terminals (300) vorsteht und sich entlang einer Längsrichtung des Schlitzes (330) erstreckt; und
eine zweite Seitenwand (350), die von der unteren Fläche des Terminals (300) vorsteht und sich entlang der Längsrichtung des Schlitzes (330) erstreckt, wobei die zweite Seitenwand (350) der ersten Seitenwand (340) in Bezug auf den Schlitz (330) gegenüberliegt.

5. Modulare Vorrichtung (10) nach Anspruch 4, wobei das Terminal (300) ferner eine Brücke (360) umfasst, die mit der ersten Seitenwand (340) und der zweiten Seitenwand (350) in einer Richtung verbunden ist, die eine Längsrichtung der ersten Seitenwand (340) und der zweiten Seitenwand (350) kreuzt.

6. Modulare Vorrichtung (10) nach Anspruch 5, wobei die Leiterplatte (220) einen oberen Aufnahmeabschnitt (228) aufweist, der ausgebildet ist, einen Ausschnitt in die Leiterplatte (220) zu bilden, so dass die Brücke (360) in den oberen Aufnahmeabschnitt (228) eingesetzt wird.

7. Modulare Vorrichtung (10) nach Anspruch 4, wobei das Terminal (300) ferner eine Anschlusselektrode (EL1) innerhalb des Terminals (300) umfasst, wobei die Anschlusselektrode (EL1) an die erste Seitenwand (340) und die zweite Seitenwand (350) angrenzt, und
wobei mindestens eine von der ersten Seitenwand (340) und der zweiten Seitenwand (350) die Anschlusselektrode (EL1) abdeckt.

## Revendications

1. Dispositif modulaire (10) comprenant:
une base (100) comprenant une électrode de connexion (TE) apparente à l'extérieur du dispositif modulaire (10);
un corps (200) comprenant une carte de circuit imprimé (220) connectée électriquement à l'électrode de connexion (TE), le corps (200) étant monté sur la base (100);
une borne (300) montée sur le corps et comprenant un port (320) connecté électriquement à la carte de circuit imprimé (220);
dans lequel la base (100) comprend:
un premier boîtier (120); et
un deuxième boîtier (110) couplé au premier boîtier (120),
dans lequel le premier boîtier (120) comprend:
une première surface (120S1) orientée vers le corps (200); et
une pluralité de fentes (122, 124, 126) formées sur la première surface (120S1),
dans lequel le deuxième boîtier (110) comprend:
au moins les unes parmi des nervures (112, 114, 116) partant de la base (100) vers le corps (200) et insérées dans la pluralité de fentes (122, 124, 126),
dans lequel au moins une de la pluralité de fentes (126) est vide avec au moins une des nervures (116),
dans lequel la carte de circuit imprimé (220) comprend une partie inférieure de réception (222, 224) de sorte que l'au moins une des nervures (112, 114) est insérée dans la partie inférieure de réception (222, 224).

2. Dispositif modulaire (10) selon la revendication 1, dans lequel la pluralité de fentes (122, 124, 126) comprend une première fente (122, 124) et une deuxième fente (126), et
dans lequel l'au moins une des nervures (112, 114, 116) comprend une première nervure (112, 114) insérée dans la première fente (122, 124) et un débris (116) formé sur la base (100), le débris (116) correspondant à la deuxième fente (126).

3. Dispositif modulaire (10) selon la revendication 2, dans lequel la première nervure (112, 114) comprend un col (113, 115) dans la partie inférieure de la première nervure (112, 114), le col (113, 115) ayant une épaisseur (T2) inférieure à l'épaisseur (T1) de la première nervure (112, 114).

4. Dispositif modulaire (10) selon la revendication 2, dans lequel la borne (300) comprend:
une fente (330) formée sur une surface inférieure de la borne (300), la carte de circuit imprimé (220) étant insérée dans la fente (330);
une première paroi latérale (340) faisant saillie de la surface inférieure de la borne (300) et partant dans le sens de la longueur de la fente (330); et
une deuxième paroi latérale (350) faisant saillie de la surface inférieure de la borne (300) et s'étendant dans le sens de la longueur de la fente (330), la deuxième paroi latérale (350) étant en regard de la première paroi latérale (340) par rapport à la fente (330).

5. Dispositif modulaire (10) selon la revendication 4, dans lequel la borne (300) comprend en outre un pont (360) relié à la première paroi latérale (340) et à la deuxième paroi latérale (350) dans une direction croisant un sens de la longueur de la première paroi latérale (340) et de la deuxième paroi latérale (350).

6. Dispositif modulaire (10) selon la revendication 5, dans lequel la carte de circuit imprimé (220) comprend une partie de réception supérieure (228) formée pour découper la carte de circuit imprimé (220) de manière à ce que le pont (360) soit inséré dans la partie de réception supérieure (228).

7. Dispositif modulaire (10) selon la revendication 4, dans lequel le borne (300) comprend en outre une électrode de borne (EL1) à l'intérieur de la borne (300), l'électrode de borne (EL1) étant adjacente à la première paroi latérale (340) et à la seconde paroi latérale (350), et
dans lequel au moins l'une parmi la première paroi latérale (340) et la deuxième paroi latérale (350) recouvre l'électrode de borne (EL1).
